# EUROPÄISCHE PATENTANMELDUNG

(11) **EP 4 697 876 A1**
(43) Veröffentlichungstag der Anmeldung: **18.02.2026**
(21) Anmeldenummer: 24194491.7
(22) Anmeldetag: 14.08.2024
(51) Int. Cl.: H05K 7/20, F28D 15/02

(54) **WÄRMELEITSYSTEM**

(71) Anmelder: Siemens Aktiengesellschaft, 80333 München (DE)
(72) Erfinder: Schwarz, Florian, 91466 Gerhardshofen (DE); Danov, Vladimir, 91056 Erlangen (DE); Neugebauer, Stephan, 91058 Erlangen (DE)
(74) Vertreter: Siemens Patent Attorneys

(57) **Zusammenfassung**

Die Erfindung betrifft ein Wärmeleitsystem zur Entwärmung verlustleistungsbehafteter elektrischer Komponenten. Des Weiteren betrifft die Erfindung eine Leistungshalbleitereinheit und einen Stromrichter mit einem solchen Wärmeleitsystem.

Das Wärmeleitsystem weist einen Wärmeaufnahmeabschnitt (12), welcher für eine thermisch leitende Anbindung an eine zu entwärmende elektrische Komponente (2) vorgesehen ist, einen Wärmeabgabeabschnitt (14), welcher oberflächenvergrößernde Mittel aufweist, und einen Wärmetransportabschnitt (13) zwischen Wärmeaufnahmeabschnitt (12) und Wärmeabgabeabschnitt (14) auf. Das Wärmeleitsystem (1) ist für einen Betrieb einer ZweiPhasen-Kühlung eingerichtet ist.

## Beschreibung

Die Erfindung betrifft ein Wärmeleitsystem zur Entwärmung verlustleistungsbehafteter elektrischer Komponenten. Des Weiteren betrifft die Erfindung eine Leistungshalbleitereinheit und einen Stromrichter mit einem solchen Wärmeleitsystem.

### Stand der Technik

Die Leistungsfähigkeit und Lebensdauer elektronischer Bauelemente, insbesondere leistungselektronischer Bauelemente, wie MOSFETs und IGBTs, sowie auch die Leistungsfähigkeit und Lebensdauer elektrischen Maschinen wie beispielsweise Motoren und E-Maschinen oder Katalysatoren, in denen chemische Prozesse ablaufen, hängen maßgeblich von ihrer Entwärmung ab bzw. den Temperaturen, denen sie ausgesetzt sind. Der Wärmefluss von der Hitzequelle zum Kühler muss oft über verschiedene Barrieren wie Bodenplatten, Substrate und thermische Interface-Materialien geleitet werden. Neben der Abkühlungseffektivität spielt auch die Abkühlungseffizienz eine wichtige Rolle. Die Zeit, die für die notwendige Entwärmung benötigt wird, bestimmt die Kühlungsart. Bisher werden hohe Wärmeströme in der Regel durch Flüssigkeitskühlung bewältigt, während geringe Wärmeströme durch Luftkühlung noch ausreichend abtransportiert werden können.

Die Implementierung der Kühlung ist jedoch je nach Anwendung sehr aufwendig. Eine effektive Kühlung im Bereich elektronischer Bauelement, insbesondere im Bereich der Leistungselektronik, erfordert bisher den Einsatz kostspieliger wärmeleitender Keramiken wie Aluminiumnitrid als Isolationsschichten. Die Verwendung aufwändig hergestellter Kühler sowie das Einbringen von Wärmespreizplatten beeinflusst die Baugröße und den Herstellungsprozess. Dies führt zu hohen Kosten aufgrund der Vielzahl unterschiedlicher Komponenten und Materialien. Insbesondere der Einsatz von teuren Metallen, insbesondere Kupfer, in großen Mengen und die Herstellungsverfahren erhöhen technischen Aufwand und Kosten.

Es ist bekannt, dass Wärmeleitsysteme verwendet werden, um einen Wärmetransport der Wärme vom Bauteil zum eigentlichen Kühlkörper zu realisieren bzw. eine Wärmeverteilung oder das dynamische Wärmeverhalten zu verbessern. Wärmeleitsysteme werden häufig bei engen Platzverhältnissen eingesetzt, um höhere Kompaktheit von Baugruppen und/oder besondere Anordnungen der zu entwärmenden Bauteile zu gewährleisten.

Aufgrund der baulichen Anforderungen für eine Luftkühlung ist eine doppelseitige Kühlung von elektrischen Bauteilen in der Praxis meistens nur schwer umsetzbar. Kühlkörper, die bei Luftkühlung verwendet werden, bieten zudem bisher nicht genug Performance, um die anfallende Wärme effizient abzuführen. Hinzu kommt, dass wiederum baulich technische Herausforderungen, wie die thermischen Widerstände, noch nicht hinreichend gelöst sind, so dass die Effizienz der Kühlung dadurch weiter beeinträchtigt ist.

Bekannte Wärmeleitungen können insbesondere Wärmerohre umfassen. Unter den Begriff Wärmerohre fallen sogenannte Heat Pipes, insbesondere pulsierende Heat Pipes, aber auch Zwei-Phasen-Thermosiphons. Alternative Wärmeleitsysteme können Vapor Chambers umfassen. Auch derartige Wärmeleitungen werden bisher bevorzugt an einen Kühlkörper angeflanscht. Um die Effizienz zu erhöhen, wird heut zu Tage bevorzugt auf teure Kupferleitungen gesetzt.

Folglich stellt es sich als technisch erforderlich dar, eine verbesserte Lösung vorzuschlagen, welche die aus dem Stand der Technik bekannten Nachteile vermeidet. Insbesondere soll die vorzuschlagende Lösung eine effiziente und baulich flexible Entwärmung von verlustleistungsbehafteten elektrischen Bauteilen ermöglichen.

Die auf eine Entwärmungsvorrichtung gerichtete Aufgabe wird durch die Merkmale des unabhängigen Patentanspruchs 1 gelöst. Zudem wird die auf eine elektrische Komponente und ein elektrisches Bauteil gerichtete Aufgabe durch die Merkmale der Patentansprüche 13 und 14 gelöst. Zudem wird in Patentanspruch 15 ein Herstellungsverfahren für eine Entwärmungsvorrichtung angegeben. Vorteile und Ausgestaltungen der Erfindung, die einzeln oder in Kombination miteinander einsetzbar sind, sind Gegenstand der Unteransprüche. In den Unteransprüchen sind weitere vorteilhafte Maßnahmen aufgelistet, die beliebig miteinander kombiniert werden können, um weitere Vorteile zu erzielen.

### Beschreibung der Erfindung

Das erfindungsgemäße Wärmeleitsystem weist wenigstens einen Wärmeaufnahmeabschnitt auf, welcher für eine thermisch leitende Anbindung an eine zu entwärmende elektrische Komponente vorgesehen ist, wenigstens einen Wärmeabgabeabschnitt, welcher wenigstens ein oberflächenvergrößerndes Mittels aufweist, und wenigstens einen Wärmetransportabschnitt zwischen Wärmeaufnahmeabschnitt und Wärmeabgabeabschnitt, wobei das Wärmeleitsystem für einen Betrieb einer Zwei-Phasen-Kühlung eingerichtet ist, indem eine durchgängige hydraulische Verbindung zwischen dem wenigstens einen Wärmeabgabeabschnitt , dem wenigstens einen Wärmetransportabschnitt und dem wenigstens einen Wärmeaufnahmeabschnitt vorgesehen ist.

Das erfindungsgemäße Wärmeleitsystem realisiert also eine Entkopplung der Wärmequelle und der Wärmesenke. Mittels dieser Entkopplung können vorteilhaft die Wärmeaufnahme am zu entwärmenden Ort effizient und mit reduzierten Einbaumaßen realisiert werden und gleichzeitig kann die Wärmeabgabe and die Umgebung effizient und nahezu unabhängig von baulichen Maßbeschränkungen gestaltet werden.

Die Ausgestaltung des Wärmeleitsystems mit einer durchgängigen hydraulischen Verbindung für den Betrieb einer Zwei-Phasen-Kühlung hat unter anderem folgenden Vorteil: Im Gegensatz zu einphasigen Kühlsystemen, bei denen ein Kühlmittel, sei es gasförmig oder flüssig, zum Beispiel Luft oder Wasser, verwendet wird, um Wärme durch einfache Wärmeleitung und Konvektion abzuleiten, nutzt die Zwei-Phasen-Kühlung den Phasenwechsel eines Kühlmittels von flüssig zu gasförmig und umgekehrt, um Wärme zu transportieren. Das Kühlmittel beginnt dabei in flüssiger Form. Es nimmt Wärme von einer Wärmequelle auf. Eine Wärmequelle im vorliegenden Kontext ist beispielsweise ein elektrisches Bauteil, eine elektronische Komponente, insbesondere ein Leistungshalbleitermodul oder ein Prozessor. Bei Aufnahme der Wärme erreicht das Kühlmittel seinen Siedepunkt und beginnt zu verdampfen. Dieser Phasenwechsel von flüssig zu gasförmig erfordert eine erhebliche Menge an Energie, die Verdampfungsenthalpie, was bedeutet, dass große Mengen an Wärme effizient an den Wärmeaufnahmeabschnitt des Wärmeleitsystems abgeführt werden können. Das gasförmige Kühlmittel wird zu einem Kondensator weitergeleitet, wo es die aufgenommene Wärme an die Umgebung abgibt. Dieser Vorgang der Wärmeabgabe wird bevorzugt durch wenigstens ein oberflächenvergrößerndes Mittel oder einen Lüfter unterstützt. Das Kühlmittel kühlt ab und kondensiert wieder zu einer Flüssigkeit, bevor es in den Kreislauf zurückgeführt wird, um den Prozess erneut zu beginnen. Insbesondere liegt also im erfindungsgemäßem Wärmeleitsystem ein Kühlmedium anteilig gasförmig und anteilig in flüssiger Phase vor.

Durch diesen Phasenwechsel kann die Zwei-Phasen-Kühlung mehr Wärme pro Volumeneinheit des Kühlmittels abführen als herkömmliche einphasige Systeme. Dies macht die Methode besonders effektiv für Anwendungen, bei denen eine hohe Wärmeableitung erforderlich ist, wie beispielsweise in elektrischen Bauteilen, insbesondere in der Leistungselektronik. Zudem hat diese Form der Kühlung den Vorteil, dass der Prozess passiv, also ohne Pumpen oder bewegliche Teile ablaufen kann, was die Zuverlässigkeit erhöht und den Wartungsaufwand reduziert. Und aufgrund der hohen Effizienz können so baulich sehr kompakte Kühlsysteme realisiert werden.

Als oberflächenvergrößerndes Mittel kann eine einzelne thermisch verbundene Finne oder Lamelle oder andersförmige Oberflächenstruktur verstanden werden, welche beispielsweise auf das Wärmeleitrohr aufgelötet sind oder bei additiver Fertigung als Oberflächenausgestaltung des Wärmeleitrohrs hergestellt werden. Es kann ein thermisch angebundener Kühlkörper verstanden werden. Eine oberflächenvergrößernde Maßnahme des Wärmeabgabeabschnitts kann auch durch geometrische Ausformung des hydraulischen Abschnitts selbst generiert sein. Bei der zu entwärmenden elektrischen Komponente handelt es sich bevorzugt um eine leistungselektronische Komponente, insbesondere ein Leistungsmodul. Unter einem Leistungsmodul ist beispielsweise eine elektronische Baugruppe zu verstehen, die verschiedene Leistungshalbleiter wie IGBTs, MOSFETs oder Dioden und oft auch zusätzliche Komponenten wie Steuer- und Schutzschaltungen in einem Gehäuse integriert. IGBTs, also Insulated Gate Bipolar Transistoren, sind eine Art von Leistungshalbleiterbauelement, das die hohe Eingangsimpedanz und schnelle Schaltgeschwindigkeit eines MOSFETs mit der hohen Strom- und niedrigen Sättigungsspannungsfähigkeit eines Bipolartransistors kombiniert. MOSFETs sind Metall-Oxid-Halbleiter-Feldeffekttransistoren, die sich durch hohe Schaltgeschwindigkeiten und die Fähigkeit auszeichnen, mit sehr geringen Eingangsströmen zu arbeiten.

Unter einem Leistungsmodul ist demnach ein elektronisches Bauteil zu verstehen, das zur Steuerung und Umwandlung von elektrischer Energie in verschiedenen Anwendungen dient.

Leistungsmodule finden Anwendung in Bereichen wie Antriebstechnik, erneuerbare Energien, Stromversorgungen, Industrieanlagen und Elektrofahrzeugen. Die Integration mehrerer Komponenten in einem Modul kann die Effizienz steigern, den Platzbedarf verringern und die Zuverlässigkeit erhöhen. Leistungsmodule sind demnach wichtige Bauteile in der Leistungselektronik.

Das erfindungsgemäße Wärmeleitsystem umfasst in einer Ausführungsvariante wenigstens einen weiteren Wärmeaufnahmeabschnitt, welcher für eine thermisch leitende Anbindung an eine weitere zu entwärmende elektrische Komponente vorgesehen ist, mit wenigstens einem weiteren Wärmetransportabschnitt zwischen dem weiteren Wärmeaufnahmeabschnitt und dem Wärmeabgabeabschnitt. Dies hat den Vorteil, dass der Wärmeabgabeabschnitt nur für eine reduzierte abzuführende Temperatur ausgelegt werden muss und nicht auf hocheffektive Wärmeabfuhr optimiert sein muss. Dies bewirkt vorteilhaft eine Material- und Platzersparnis. Anstatt für die doppelte Leistung ausgelegt zu sein, genügt bei der erfindungsgemäßen Ausführungsform des Wärmeleitsystems mit zwei zu entwärmenden Komponenten eine Auslegung für niedrigere Temperaturen, insbesondere für maximal 60% der Leistungssumme der beiden Komponenten, oder für maximal 70% der Leistungssumme der beiden Komponenten oder für maximal 80% der Leistungssumme der beiden Komponenten. Dies kann vorteilhaft für Umrichter mit niedrigen Ausgangsfrequenzen eingesetzt werden.

Das erfindungsgemäße Wärmeleitsystem ist in einer Ausführungsvariante als Vapor Chamber ausgestaltet. Eine Vapor Chamber, also eine Dampfkammer, ist ein Kühlgerät, das häufig in der Elektronik und in Anwendungen verwendet wird, in denen eine besonders effiziente Wärmeableitung erforderlich ist, bei denen herkömmliche Kühlmethoden wie einfache Wärmeleitpaste und Kühlkörper möglicherweise nicht ausreichen. Die Vapor Chamber nutzt die Prinzipien der Phasenänderung und Wärmeleitung, um Wärme von einer heißen Stelle zu einer kühleren Stelle zu transportieren.

Eine Vapor Chamber besteht aus einer flachen, hermetisch abgedichteten Kammer, die eine kleine Menge einer Arbeitsflüssigkeit, zum Beispiel Wasser oder Alkohol, und eine Kapillarstruktur, insbesondere ein Dochtmaterial enthält. Wenn Wärme an einem Punkt, zum Beispiel an einem elektronischen Bauteil, auf die Vapor Chamber übertragen wird, verdampft die Arbeitsflüssigkeit an dieser Stelle. Der Verdampfungsprozess nimmt Wärme auf, was zu einer Abkühlung der erhitzten Komponente führt. Der entstehende Dampf breitet sich schnell innerhalb der Kammer aus und bewegt sich in Richtung kühlerer Bereiche der Kammer. In den kühleren Bereichen der Kammer kondensiert der Dampf wieder zu Flüssigkeit und gibt dabei die aufgenommene Wärme ab, zum Beispiel an einen Kühlkörper. Die kondensierte Flüssigkeit wird durch die Kapillarstruktur oder Schwerkraft zurück zu den heißen Bereichen der Kammer transportiert, wo der Zyklus von neuem beginnt. Vapor Chambers sind also besonders effizient, weil sie Wärme schnell und gleichmäßig über eine große Fläche verteilen können.

Alternativ ist das erfindungsgemäße Wärmeleitsystem als Zwei-Phasen-Thermosiphon ausgestaltet. Ein Zwei-Phasen-Thermosiphon ist ein thermisches Managementsystem, das ebenso die Phasenwechsel von Flüssigkeit zu Dampf und wieder zurück zu Flüssigkeit nutzt, um Wärme effizient zu transportieren und abzuleiten nutzt also die latente Wärme, die bei Phasenwechseln übertragen wird. Der Zwei-Phasen-Thermosiphon weist zwischen Verdampfer und Kondensator Flüssigkeits- und Dampfkanäle als Verbindungselemente auf, durch die die Flüssigkeit und der Dampf zwischen Verdampfer und Kondensator zirkulieren. Als Arbeitsmedium findet eine Flüssigkeit mit einem geeigneten Siedepunkt Anwendung. Anwendung findet der Zwei-Phasen-Thermosiphon bevorzugt in der Elektronikkühlung, insbesondere in Computern zur Entwärmung von Prozessoren, aber auch in der Solarthermie, in Solarkollektoren zur effizienteren Wärmeübertragung.

In den vorstehend beschriebenen Ausführungsformen umfasst also das Wärmeleitsystem, wenigstens ein Rohr oder einen Kanal mit mehreren Kapillaren, mit poröser Struktur oder Kapillarstruktur. Diese Ausführungsformen sind auf Grund der gewährleisteten hocheffizienten Wärmeabführung geeignet, eine Entkopplung von Wärmequelle und Wärmesenke zu gewährleisten. Es können relativ weite Entfernungen, insbesondere Wärmetransportabschnitte von etwa 1 m realisiert werden.

In einer besonders vorteilhaften Ausführungsform der Erfindung umfasst das Wärmeleitsystem eine Heatpipe beziehungsweise ist als Heatpipe ausgeführt. Besonders bevorzugt umfasst es eine pulsierende Heatpipe beziehungsweise ist als pulsierende Heatpipe ausgestaltet.

Bei dem Betrieb der pulsierenden Heatpipe (PHP), auch als oszillierende Heatpipe bezeichnet, wird keine poröse Struktur benötigt. Die Innenseite des Rohres kann auch glatt ausgeführt sein. Auch bei der pulsierenden Heatpipe erfolgt der die Wärmeübertragung über eine Flüssigkeit, wobei Teile der Flüssigkeit gasförmig im Rohr vorhanden ist. Aufgrund des Wärmeeintrags beginnt die Flüssigkeit im Rohr sich hin- und her zu bewegen. Dieses Pulsieren gibt der Heatpipe seinen Namen. Das Rückfließen der Flüssigkeit zur Wärmequelle, an der durch das Verdampfen die Kühlwirkung entfaltet wird, erfolgt durch wechselnde Siede- und Kondensationsprozesse, unterstützt durch die Geometrie des Rohres, das den Kanal bildet. Die Abmessungen, insbesondere der Querschnitt des Kanals wird so gewählt, dass der Effekt der Schwerkraft gegenüber der Oberflächenspannung geringer ist und so die Flüssigkeit sich auch entgegen der Schwerkraft im Kanal ausbreiten kann. Mit anderen Worten ist die Geometrie derart ausgestaltet, dass der Effekt der Oberflächenspannung gegenüber der Schwerkraft dominiert. Somit ist für die pulsierende Heatpipe keine poröse Struktur mehr erforderlich, sondern die Kapillarwirkung kommt aufgrund der Geometrie zur Wirkung.

Insbesondere weist der Innenquerschnitt einer PHP eine minimale Ausdehnung im Bereich von 0,5 mm bis 5 mm auf. Dies hat unter anderem den Vorteil, dass Formanpassungen der PHP vorgenommen werden können, ohne eine Kapillarstruktur oder poröse Struktur zu verletzen oder zu unterbrechen. Mittels der Biegbarkeit der PHP kann eine noch bessere oder weitere Entkopplung von Wärmequelle zu Wärmesenke gewährleistet werden. Beispielhaft können mehrere PHP-Kanäle in einem Strangpressprofil ausgebildet sein, wie es beispielsweise aus der WO 2022/128474 A1 bekannt ist.

Besonders vorteilhaft kann der Einsatz einer PHP bei entsprechender Auslegung zusätzlich zum Wärmeabtransport auch zur Homogenisierung der Temperatur verschiedener Module beitragen. Hierdurch können beispielsweise bestimmte Arten von Halbleiterbauelementen, zum Beispiel Bipolar-Transistoren, leichter parallelgeschaltet werden.

Alle Zwei-Phasen-Kühlungssysteme haben den Vorteil auf Grund geringerer Materialstärke durch fluidbasierte, konvektive Wärmespreizung, statt Wärmeleitung gewichtsmäßig deutlich leichter zu sein. Es besteht keine Notwendigkeit für breite, gepresste Kühlkörperrippen.

Dadurch wird auch vorteilhaft eine Einsparung von Material gegenüber konventionellen Lösungen realisiert. Die Verringerung des notwendigen Materials sowie das verringerte Gewicht verringert demnach auch den CO₂-Fußabdruck.

In einer weiteren vorteilhaften Ausführungsform des erfindungsgemäßen Wärmeleitsystems weist der Wärmetransportabschnitt eine Mindestlänge von 0,1 m, 0,5 m oder 1 m auf. Insbesondere weist der Wärmetransportabschnitt eine Mindestlänge von 0,2 m, 0,3 m, 0,4 m, 0,6 m, 0,7 m, 0,8 m, oder 0,9 m auf.

Mit einer Mindestlänge des Wärmetransportabschnitts von 0,1 m oder 0,2 m können bevorzugt Wärmeleitsysteme für die vertikale Integration von Baugruppen realisiert werden, die eine effektive Ableitung der Wärme gewährleisten, ohne die Bauhöhe der Baugruppe zu vergrößern. Mit einer Mindestlänge von 0,3 m, 0,4 m oder 0,5 m können insbesondere Wärmeleitsysteme realisiert werden, welche eine Vielzahl von zu entwärmenden Elektronikkomponenten, insbesondere in komplexer Anordnung bedienen. Mit einer Mindestlänge des Wärmetransportabschnitts von 0,6 m, 0,7 m, 0,8 m, 0,9 m oder 1 m können Wärmeleitsysteme realisiert werden, welche eine Vielzahl von zu entwärmenden Elektronikkomponenten beidseitig der Komponenten entwärmen oder welche größere Komponenten, wie Spulenwicklungen entwärmen. Zudem sind Anwendungen denkbar, in denen eine Wärmeableitung aus Schaltschränken oder aus Antriebssystemen erfolgt.

Die Mindestlänge hat also eine vorteilhafte Wirkung hinsichtlich verschiedener Anwendungen, insbesondere der vertikalen Integration. Sie gewährleistet eine

örtliche Entkopplung von Wärmequelle und Kühlkörper. Die vorgeschlagenen Mindestlängen der Wärmetransportabschnitte sind besonders effektiv realisierbar mittels einer pulsierenden Heatpipe. Große Strecken zwischen Wärmequelle und -senke überbrücken zu können eröffnet neue Designfreiheiten und sehr einfache und kostengünstige Umsetzungen von mehrseitigen Luftkühlungen sowie die Entwärmung mehrerer Elektronikmodule gleichzeitig.

In einer weiteren vorteilhaften Ausführungsform des erfindungsgemäßen Wärmeleitsystems sind der wenigstens eine Wärmeaufnahmeabschnitt, der Wärmetransportabschnitt und der Wärmeabgabeabschnitt fügestellenfrei ausgebildet. Und in einer besonders vorteilhaften Ausführungsform der Erfindung ist das erfindungsgemäße Wärmeleitsystem in länglicher Form ausgebildet ist, wobei sich Wärmeaufnahmeabschnitt, Wärmetransportabschnitt und Wärmeabgabeabschnitt entlang dieser länglichen Form aneinanderreihen und ineinander übergehen, insbesondere fügestellenfrei ineinander übergehen. Das Wärmeleitsystem ist also bevorzugt in einer Röhren-, Strang- oder Kanalform ausgestaltet. Beispielsweise kann das Wärmeleitsystem als Strangpress-PHPs realisiert sein. Derartige geeignete Strangpressprofile können als Zulieferbauteil erworben werden.

In einer weiteren vorteilhaften Ausführungsform des vorstehend beschriebenen erfindungsgemäßen Wärmeleitsystems mit pulsierender Heatpipe weist der Wärmetransportabschnitt wenigstens eine Formadaption an das zu entwärmende elektrische System auf. Durch Verzicht auf poröse oder kapillare Strukturen ist das nunmehr vorliegende Wärmeleitsystem besonders geeignet, durch Biegungen und Stufen an Bauteilgrößen und - formen angepasst zu werden. Gewerblich erhältliche Strangpressprofile sind dazu sehr geeignet. Diese können auch vollautomatisiert in vorgebbare Form gefaltet werden. Zudem sind die Materialien bevorzugt so gewählt, zum Beispiel so, dass sie lötbar sind, insbesondere für die thermische Anbindung an die Wärmequelle aber auch für die Anbindung von beispielsweise Kühllamellen.

In einer weiteren vorteilhaften Ausführungsform des vorstehend beschriebenen erfindungsgemäßen Wärmeleitsystems ist der Wärmeabgabeabschnitt als Kühlkörper ausgestaltet ist. Das heißt, dass der Wärmeabgabeabschnitt insbesondere eine große Oberfläche aufweist. Die vergrößerte Oberfläche eines Kühlkörpers ermöglicht eine effektive Wärmeabgabe an die Umgebungsluft. Dies geschieht hauptsächlich durch Konvektion und Wärmestrahlung und kann durch zusätzliche Lüfter unterstützt werden. In vorteilhaften Anwendungen wird zum Beispiel ein Lüfter verwendet, der den Luftstrom über den Kühlkörper erhöhen und so die Wärmeabgabe weiter verbessern kann, da so die erhitzte Luft schneller entfernt und durch kühlere Luft ersetzt wird.

Die Effizienz eines Kühlkörpers hängt dabei von weiteren Faktoren ab, einschließlich des Materials, der Form und Größe, der Luftzirkulation und der Wärmemenge, die abgeführt werden muss. In einer besonders vorteilhaften Ausführungsform des vorstehend beschriebenen erfindungsgemäßen Wärmeleitsystems mit Kühlkörperausgestaltung des Wärmeabgabeabschnitts, weist der Kühlkörper Kühlrippen auf. Dabei sind unter Kühlrippen auch Kühllamellen oder Kühlfinnen zu verstehen oder andere oberflächenvergrößernde Geometrien. Die Ausgestaltung des Wärmeabgabeabschnitts mit Kühlrippen hat unter anderem den Vorteil das Volumen der Feststoff-zu-Luft-Schnittstelle zu verringern.

In einer weiteren besonders vorteilhaften Ausführungsform des vorstehend beschriebenen erfindungsgemäßen Wärmeleitsystems mit Kühlkörperausgestaltung des Wärmeabgabeabschnitts, weist der Wärmeabgabeabschnitt gekrümmte, wechselseitig gekrümmte, mäanderförmige oder U-förmig ausgebildete Abschnitte auf. Derartige Kühlkörperformen sind beispielsweise aus der WO 2022/128474 A1 für PHPs bekannt. Durch diese Formen wird die Länge des Wärmeabgabeabschnitts vergrößert und somit die Wärmeabgabe an die Umgebung vorbessert.

Besonders vorteilhaft können derartig geformte Abschnitte mit PHPs erzeugt werden. Als PHP-Grundkörper können insbesondere Strangpressprofile hergenommen werden. Diese können für High-Performance-Anwendungen Kupfer umfassen beziehungsweise aus Kupfer gebildet sein. Beispielsweise umfasst das Wärmeleitsystem Aluminium oder ist aus Aluminium gefertigt. Dies stellt eine kostengünstigere Variante dar. Es hat sich gezeigt, dass fügestellenfreie Wärmeleitsyteme aus Aluminiumstrangpressprofilen eine bis zu fünfmal höhere Wärmeleitung zeigen als Vollkupfer. Zudem sind derartige Strangpressprofile vollautomatisiert herstellbar. Alternativ können auch andere Materialien verwendet werden, welche zum Beispiel für einen additiven Fertigungsprozess geeignet sind.

Bevorzugt werden alle Abschnitte des Wärmeleitsystems aus demselben Material gefertigt, zum Beispiel wie obenstehend beschrieben mittels eines Strangpressprofils. Das Wärmeleitsystem wird im Wärmeaufnahmeabschnitt direkt an die Elektronik angeschlossen und thermisch leitend angebunden. Der Wärmeleitabschnitt wird dann insbesondere aus dem elektrischen Gerät herausgeführt. Und schließlich bildet der Wärmeabgabeabschnitt noch gleichzeitig einen Kühlkörper aus. Das funktioniert einseitig, als auch mit mehreren Wärmequellen. Das vorgeschlagene Wärmeleitsystem realisiert problemlos Wärmeleitstrecken von über einem Meter.

Die erfindungsgemäße elektrische Komponente ist mit einem erfindungsgemäßen Wärmeleitsystem gemäß einer der vorstehend beschriebenen Ausführungsformen angeordnet, wobei die elektrische Komponente thermisch leitend mit dem Wärmeleitsystem verbunden ist. Insbesondere ist als elektrische Komponente ein Leistungshalbleitermodul vorgesehen.

Die erfindungsgemäße elektrische Komponente hat demnach den Vorteil, mittels der örtlichen Entkopplung der Wärmeaufnahme von der Wärmeabgabe, effizient gekühlt zu werden bei gleichzeitig reduzierten Einbauanforderungen. Die Wärmeabgabe and die Umgebung kann an nahezu beliebigen Orten und auch an mehreren Orten effizient erfolgen und die elektrische Komponente kann mit minimierter Bauhöhe sehr flexibel integriert werden.

Das erfindungsgemäße elektrische Gerät, insbesondere Stromrichter, weist ein Wärmeleitsystem gemäß einer der vorstehend beschriebenen Ausführungsformen oder eine erfindungsgemäße elektrischen Komponente auf. Das erfindungsgemäße elektrische Gerät ist insbesondere ein Stromrichter.

Das erfindungsgemäße elektrische Gerät hat insbesondere den Vorteil, mittels der örtlichen Entkopplung der Wärmeaufnahme von der Wärmeabgabe, sehr effizient gekühlt zu werden, und zum Beispiel auch mehrseitig Wärmeabgabeabschnitte aufzuweisen.

Bei dem erfindungsgemäßen Herstellungsverfahren für ein erfindungsgemäßes Wärmeleitsystem gemäß einer der vorstehend beschriebenen Ausführungsformen, wird eine Wärmeleitung, insbesondere ein Strangpressprofil, in eine Form entsprechend einer Außengestalt einer zu entwärmende elektrischen Komponente und/oder einer Anordnung wenigstens einer zu entwärmenden elektrischen Komponente gefaltet. Insbesondere ist das Strangpressprofil fügestellenfrei.

### Figurenbeschreibung

Im Folgenden wird die Erfindung anhand der in den Figuren dargestellten Ausführungsbeispiele näher beschrieben. In den Ausführungsbeispielen und Figuren können gleiche oder gleich wirkende Elemente jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, zur besseren Darstellbarkeit und/oder zum besseren Verständnis im Verhältnis größer dimensioniert dargestellt sein. Merkmale, Eigenschaften und Vorteile der vorliegenden Erfindung werden in der nachfolgenden Beschreibung unter Bezugnahme auf die beiliegende Figuren erläutert. Darin zeigen schematisch:
- Figur 1: zeigt ein Elektronikmodul (2), befestigt auf einer pulsierenden Heatpipe (PHP) als Wärmeleitsystem (1), welche die Wärme des Elektronikmoduls (2) abführt und gleichzeitig einen Kühlkörper (4) ausbildet,
- Figur 2: zeigt eine doppelseitige Entwärmung eines Elektronikmoduls (2) mittels einer gefalteten PHP als Wärmeleitsystem (1),
- Figur 3: zeigt eine Anordnung eines gefalteten Wärmeleitsystems (1) mit mehreren Elektronikmodulen (2),
- Figur 4: zeigt eine Anbindung eines gehäusten Elektronikmoduls (2) und weiteren Bauteilen (25) an eine PHP als Wärmeleitsystem (1),
- Figur 5: zeigt eine in ihrer Formgebung and die Bauhöhen der weiteren Bauteile (25) angepasste PHP als Wärmeleitsystem (1),
- Figur 6: zeigt eine Anbindung eines gehäusten Elektronikmoduls (2) an eine PHP in einem Gerätegehäuse (62),
- Figur 7: zeigt eine Anbindung von Elektronikmodulen (2) jeweils beidseitig einer PHP als Wärmeleitsystem (1),
- Figur 8: zeigt eine alternative Ausgestaltung eines Kühlkörper (4) mittels Formung des Wärmeleitsystems (1),
- Figur 9: zeigt eine weitere alternative Ausgestaltung eines Kühlkörper (4) mittels Formung des Wärmeleitsystems (1),
- Figur 10: zeigt eine weitere Ausführung des Wärmeleitsystems (1) in Kombination mit einem elektrischen Bauteil (2),
- Figur 11: zeigt eine weitere Ausführung des Wärmeleitsystems (1) in Kombination mit einem alternativen elektrischen Bauteil (2),
- Figur 12: zeigt eine Ausführung des Wärmeleitsystems (1) in Kombination mit einem elektrischen Bauteil (2) in einem Gerätegehäuse (62),
- Figur 13: zeigt eine thermische Anbindung nicht-ebener Außenflächen eines elektrischen Bauteils (2), wie etwa einer Drosselwicklung, an eine formangepasste PHP als Wärmeleitsystem (1),
- Figur 14: zeigt eine thermische Anbindung nicht planar oder parallel angeordneter Verlustleistungskomponenten (2),
- Figur 15: zeigt eine weitere Anbindung nicht planar angeordneter Elektronikmodule (2) an eine frei designte PHP als Wärmeleitsystem (1) und Kühlkörper (4),
- Figur 16: zeigt eine weitere beidseitige Anbindung von Elektronikmodulen (2) an eine frei designte PHP als Wärmeleitsystem (1) und Kühlkörper (4),
- Figur 17: zeigt eine alternative beidseitige Anbindung von Elektronikmodulen (2) an eine frei designte PHP als Wärmeleitsystem (1) und Kühlkörper (4), ...
- Figur 18: zeigt eine thermische Anbindung konzentrisch angeordneter Elektronikmodule (2) an einer frei designte PHP als Wärmeleitsystem (1) und Kühlkörper (4).

Obwohl die Erfindung im Detail durch bevorzugte Ausführungsbeispiele näher illustriert und beschrieben wurde, ist die Erfindung nicht durch die offenbarten Beispiele eingeschränkt. Variationen hiervon können vom Fachmann abgeleitet werden, ohne den Schutzumfang der Erfindung, wie er durch die Patentansprüche definiert wird, zu verlassen.

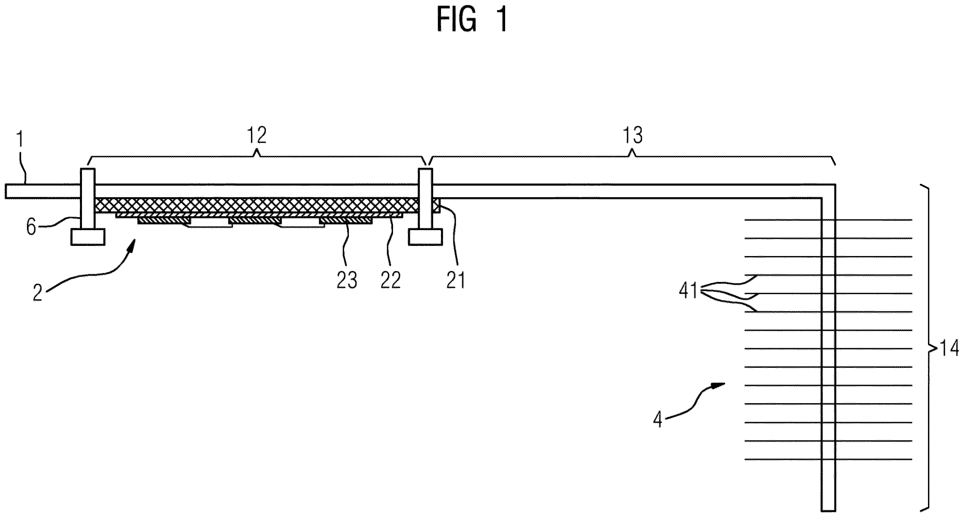

Alle Figuren 1 bis 14 zeigen jeweils schematisch Seitenansichten von Varianten des vorgeschlagenen Wärmeleitsystems 1.

Die Figur 1 zeigt zunächst eine zu entwärmende elektrische Komponente 2. Darunter kann ein Elektronikmodul 2, insbesondere ein Leistungsmodul 2 verstanden werden. Insbesondere weist die in Figur 1 gezeigte elektrische Komponente 2 ein Substrat 21 auf, zum Beispiel eine Leiterplatte 21, darauf eine elektrisch leitende Schicht 22, etwa eine Kupferschicht 22, und wiederum darauf angeordnet sind drei elektrische Bauteile 23, zum Beispiel Halbleiter-Chips 23. Das Substrat 21 ist dabei besonders zur thermischen Anbindung an den Wärmeaufnahmeabschnitt 12 des Wärmeleitsystems 1 geeignet, das heißt es ist elektrisch isolierend aber gut thermisch leitend. Es können auch mechanische Halterungen 6 zur Montage des Elektronikmoduls 2 auf dem Wärmeleitsystem 1 vorgesehen sein.

An den Wärmeaufnahmeabschnitt 12 schließt sich, insbesondere fügenstellenfrei, der Wärmeleitabschnitt 13 an. Dieser kann über 1 m Wärmeleitstrecke überwinden. Der Vorteil des besonders langen Wärmetransportabschnitts 13 besteht darin, dass die Wärmeaufnahme an der Wärmequelle und die Wärmeabgabe and die Umgebung örtlich voneinander entkoppelt sind.

An der Wärmesenke angekommen, insbesondere an der Umgebungsluft, schließt sich noch der Wärmeabgabeabschnitt 14 an, welcher in der Figur 1als Kühlkörper 4 mit Kühlrippen 41 gezeigt ist. Die Kühlrippen 41 vergrößern die Oberfläche des Kühlkörpers 4 über die Wärme and die Umgebung abgeben wird. Der Wärmeabtransport kann noch durch einen Lüfter verbessert werden.

Bei großem Verhältnis von Heizfläche zu Kondensator, können Zusatzheizungen vorgesehen werden. Wenn der Abstand zwischen Heizfläche und Kondensator groß ist, kann es vorteilhaft sein, auf der Strecke dazwischen zusätzlich zu heizen, um die Temperatur am Kondensator zu erhöhen. Bei zu großer Temperaturdifferenz zwischen Warm- und Kaltseite strömt es nicht mehr gut.

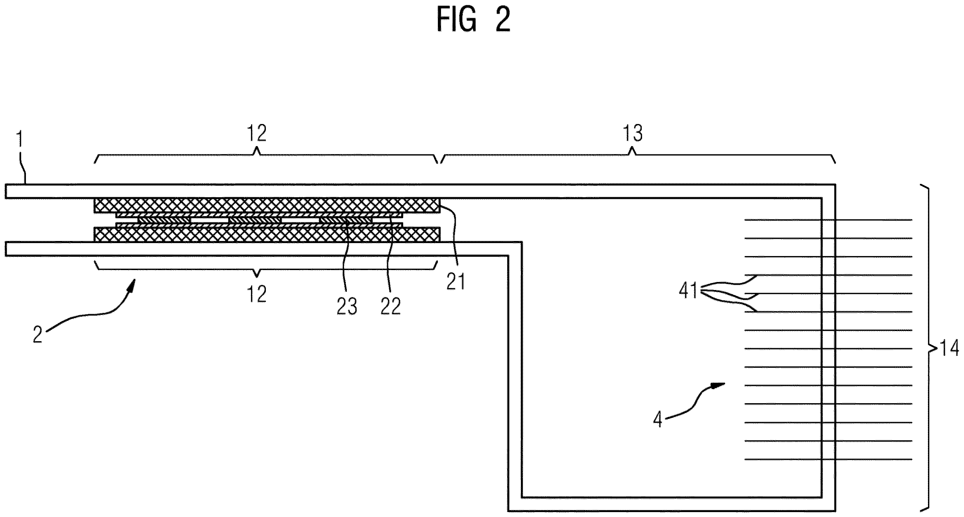

Die Figur 2 zeigt eine doppelseitige Entwärmung eines Elektronikmoduls 2 mittels einer gefalteten PHP als Wärmeleitsystem 1. Das Elektronikmodul 2 ist aus zwei gegenüberliegenden Substraten 21 mit jeweils elektrisch leitfähiger Beschichtung 22 und verschiedenen Bauteilen 23 gebildet. Die Substrate 21 bilden Ober- und Unterseite des Elektronikmoduls 2 und sind beide jeweils thermisch an dasselbe Wärmeleitsystem 1 angebunden. Dieses weist demnach zwei Wärmeaufnahmeabschnitte 12 auf. An beide Wärmeaufnahmeabschnitte 12 schließt jeweils ein Wärmetransportabschnitt 13 an. Beide Wärmetransportabschnitte 13 schließen beidseitig an den Wärmeabgabeabschnitt 14 an. Dieser ist wiederum als Kühlkörper 4 mit Kühlrippen 41 ausgebildet. In Figur 2 ist auch bereits gezeigt, dass das Wärmeleitsystem 1 faltbar ist. Die Wärmetransportabschnitte 13 führen teilweise um mehrere Ecken zum Kühlkörper 4.

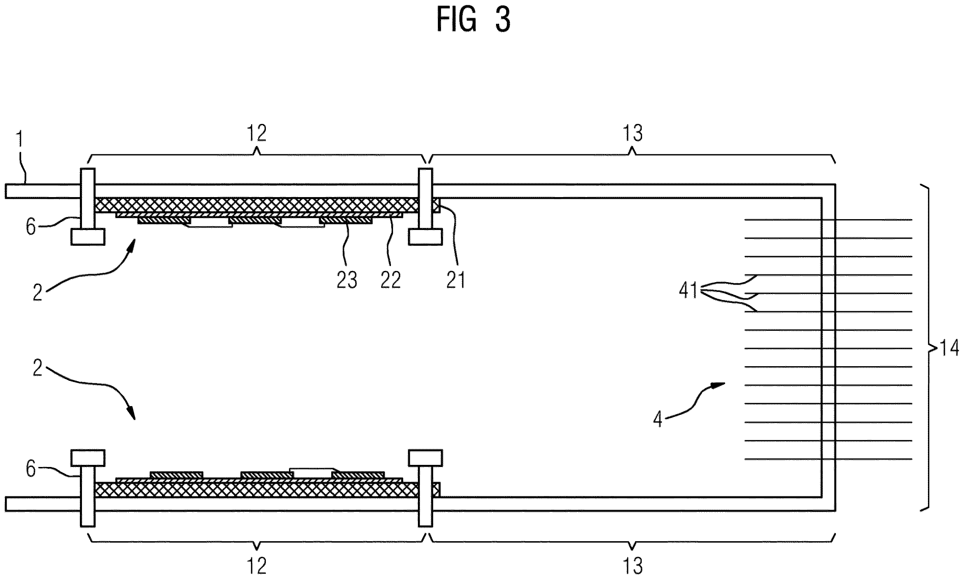

Die Figur 3 schließlich zeigt eine Anordnung eines gefalteten Wärmeleitsystems 1 mit mehreren Elektronikmodulen 2. Vergleichbar zur Variante der Figur 2, weist das Wärmeleitsystem 1 beidseitig des Wärmeabgabeabschnitts 14 jeweils einen Wärmetransportabschnitt 13 auf. Diese Wärmetransportabschnitte münden aber nicht beidseitig an ein Elektronikmodul 2 sondern binden zwei separate Elektronikmodule 2 thermisch an. Die gezeigten Elektronikmodule 2 weisen wiederum Substrate 21 mit jeweils elektrisch leitfähiger Beschichtung 22 und verschiedenen Bauteilen 23 auf. Hier wird der bauliche Vorteil der langen Wärmeleitstrecken schon verdeutlicht.

Beim Betrieb der Zwei-Phasen-Kühlung befindet sich ein Kühlmittel, beispielsweise Wasser, im Wärmeleitsystem 1. In der Flüssigkeitsphase nimmt das Kühlmittel im

Wärmeaufnahmeabschnitt 12 Wärme von der Wärmequelle 2, zum Beispiel einem Leistungsmodul 2 auf. Durch die Aufnahme der Wärme erreicht das Kühlmittel seinen Siedepunkt und beginnt zu verdampfen. Das nun gasförmige Kühlmittel wird zur Wärmesenke, dem Wärmeabgabeabschnitt 14 geleitet. Bei den Zwei-Phasen-Kühlsystemen heißt der Wärmeabgabeabschnitt 14 Kondensator. Dort wird die aufgenommene Wärme an die Umgebung abgegeben. Das Kühlmittel kühlt ab und kondensiert wieder zu einer Flüssigkeit, bevor es in den Kreislauf zurückgeführt wird, um den Prozess erneut im Wärmeaufnahmeabschnitt 12 zu beginnen. Das Kühlmedium im Wärmeleitsystem 1 liegt also anteilig gasförmig und anteilig in flüssiger Phase vor.

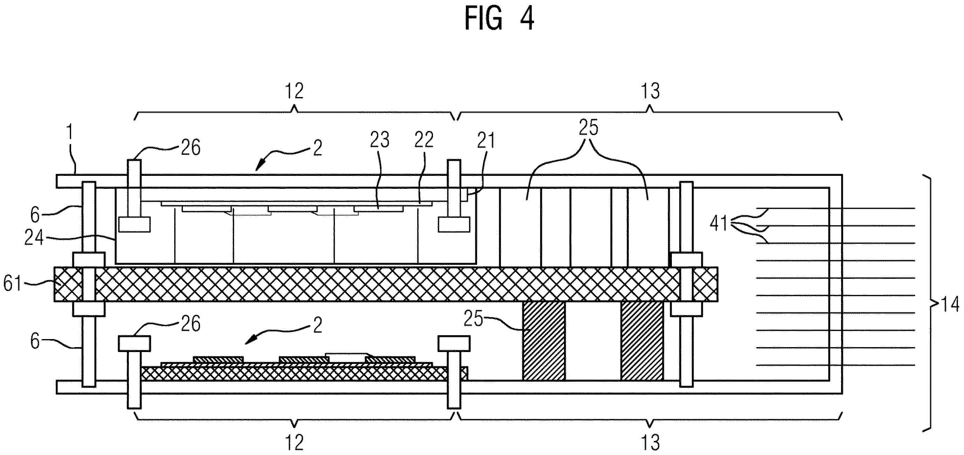

Die Figur 4 zeigt eine thermische Anbindung eines gehäusten Elektronikmoduls 2 und weiterer Bauteilen 25 an eine PHP als Wärmeleitsystem 1. Auch die elektronischen Bauteile 23 können ihrerseits gehäust vorliegen.

Unter einem gehäusten Chip ist beispielsweise ein integrierter Schaltkreis zu verstehen, der in einem schützenden Gehäuse, einem sogenannten Package untergebracht ist. Dieses Gehäuse 24 schützt den empfindlichen Halbleiterchip 23 im Inneren vor mechanischen Beschädigungen, Feuchtigkeit und anderen Umwelteinflüssen. Das Gehäuse 24 enthält auch Anschlüsse 26, Pins oder Pads, die es ermöglichen, den Chip 23 in elektronische Schaltungen zu integrieren und mit anderen Komponenten zu verbinden. Es gibt verschiedene Arten von Gehäusen für Chips. Die Wahl des Gehäuses hängt von verschiedenen Faktoren ab, wie zum Beispiel der Anwendung, den Platzanforderungen und den elektrischen Spezifikationen. Ein gehäuster Chip ist also insbesondere ein integrierter Schaltkreis, der in einem schützenden Gehäuse 24 oder Package untergebracht ist, um seine Funktionalität und Zuverlässigkeit zu gewährleisten.

Des Weiteren sind in der Figur 4 weitere elektrische Bauteile 25 gezeigt. Dies können beispielsweise Kondensatoren sein. Vom Wärmeleitsystem 1 her ist die Figur 4 ähnlich zur in Figur 3 gezeigten Variante. Zusätzlich jedoch ist eine Leiterplatte 61 gezeigt, auf der Elektronikmodule 2, weitere Bauteile und Kondensatoren 25 beidseitig angebracht sind und welche Leiterplatte 61 wiederum über Halterungen 6 mit dem Wärmeleitsystem 1 mechanisch verbunden ist. Die thermische Anbindung erfolgt jedoch jeweils direkt an den Wärmequellen 2/25. Diese Ausführungsform verdeutlicht den Vorteil, dass mehrere Module 2 gleichzeitig über dasselbe Wärmeleitsystem gekühlt werden können.

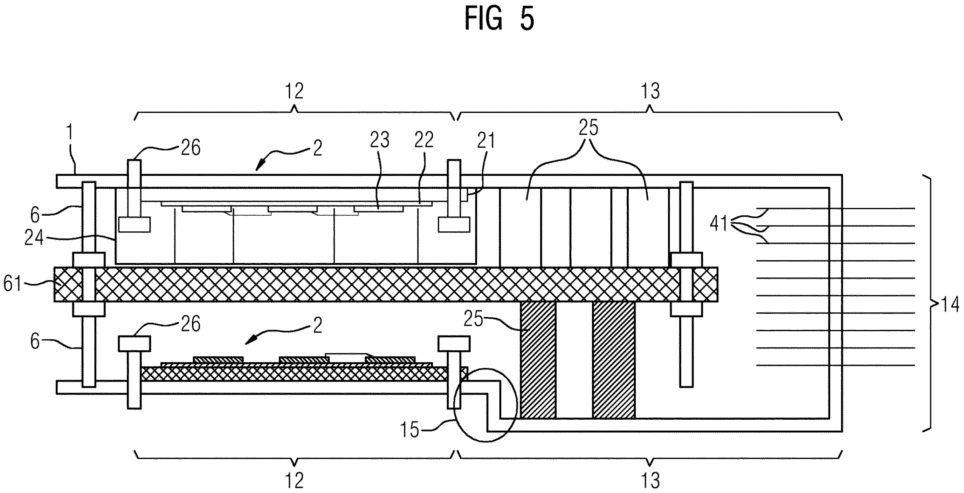

Die Figur 5 zeigt eine in ihrer Formgebung and die Bauhöhen der weiteren Bauteile 25 angepasste PHP als Wärmeleitsystem 1. Der Wärmetransportabschnitt 13 durchläuft dazu eine Stufe 15.

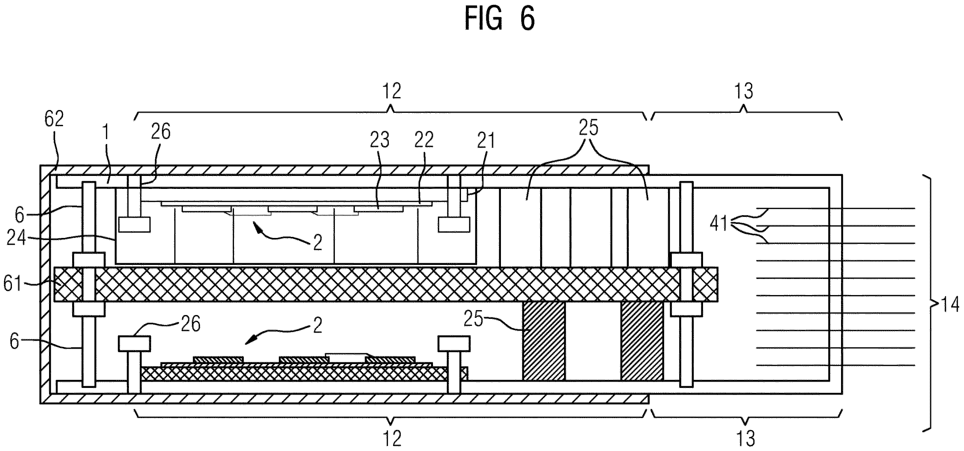

Die Figur 6 zeigt eine thermische Anbindung eines gehäusten Elektronikmoduls 2 an eine PHP vergleichbar zur Figur 4, wobei sich der gesamte zu entwärmende Aufbau aus Elektronikmodulen 2 und weiteren Bauteilen 25 in einem Gerätegehäuse 62 befindet. Die Wärmeaufnahmeabschnitte 12 verlaufen innerhalb dieses Gehäuses 62, die Wärmetransportabschnitte 13 transportieren die Wärme aus dem Gehäuse 62 und die Wärmeabgabe erfolgt außerhalb des Gehäuses 63 über den Kühlkörper 4. Diese Ausgestaltung verdeutlicht den Vorteil für die vertikale Integration.

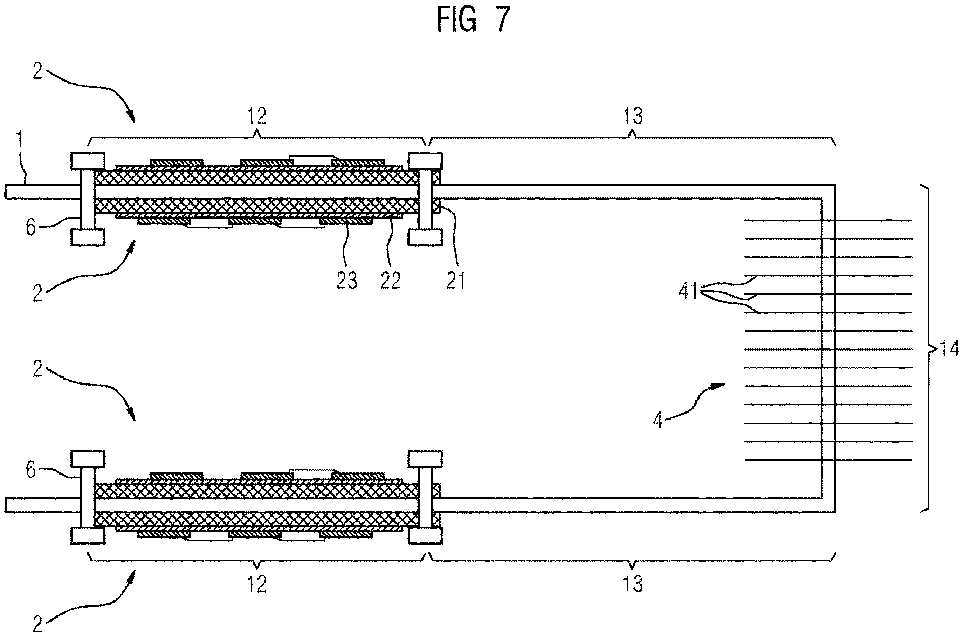

Die Figur 7 zeigt eine thermische Anbindung von Elektronikmodulen 2 jeweils beidseitig einer PHP als Wärmeleitsystem 1, vom Aufbau her eine Kombination der in den Figuren 2 und 3 gezeigten Varianten. Das Wärmeleitsystem 1 koppelt an zwei verschiedenen Orten jeweils zwei Elektronikmodule 2 zu beiden Seiten der Wärmeleitung 2 an. Hierbei sei angemerkt, dass stets eine Seitenansicht gezeigt ist. Das Wärmeleitsystem 1 kann mehrere Wärmeleitkanäle umfassen, die jeweils für eine Zwei-Phasen-Kühlung eingerichtet sind. Diese mehreren Kanäle können nebeneinander angeordnet sein. Das Wärmeleitsystem 1 kann sich also senkrecht zur Bildebene flächig erstrecken. Insbesondere ist das Wärmeleitsystem mittels eines Strangpressprofils ausgbildet.

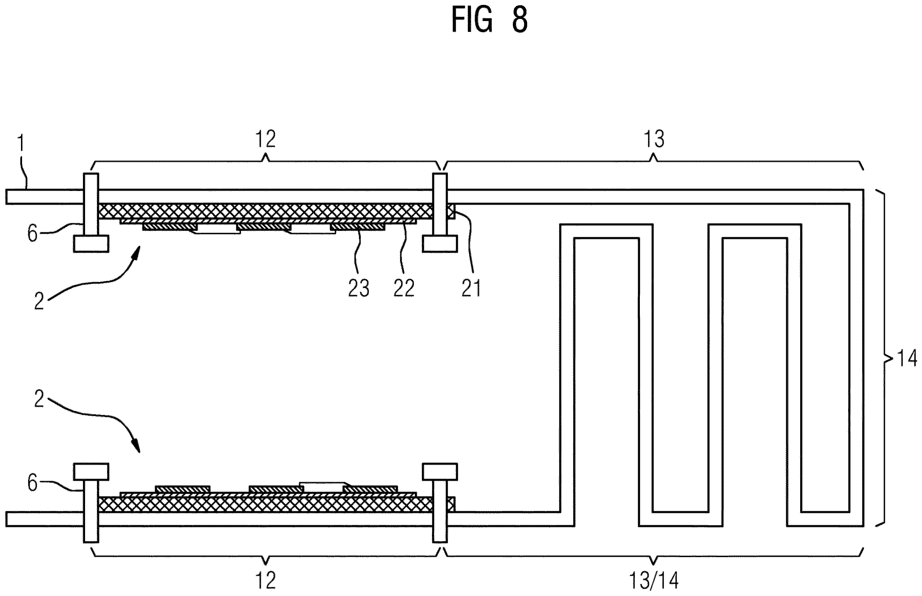

In der Figur 8 ist eine alternative Ausgestaltung eines Kühlkörper 4 mittels Formung des Wärmeleitsystems 1 gezeigt. Der Aufbau entspricht auf der Wärmeaufnahmeseite zunächst der Ausgestaltung in Figur 3. Die Ausformung des Kühlkörpers 4 jedoch wird nun alternativ oder zusätzlich zu den Kühlrippen mittels Vergrößerung des Wärmeabgabeabschnitts 14 geschaffen. In der Figur 8 sind mehrere Faltungen des Wärmeleitsystems 13/14 gezeigt.

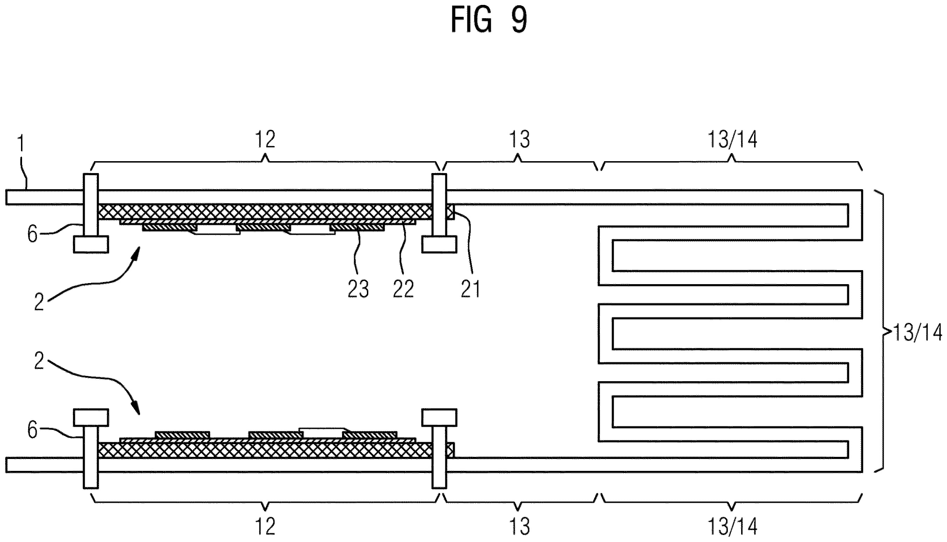

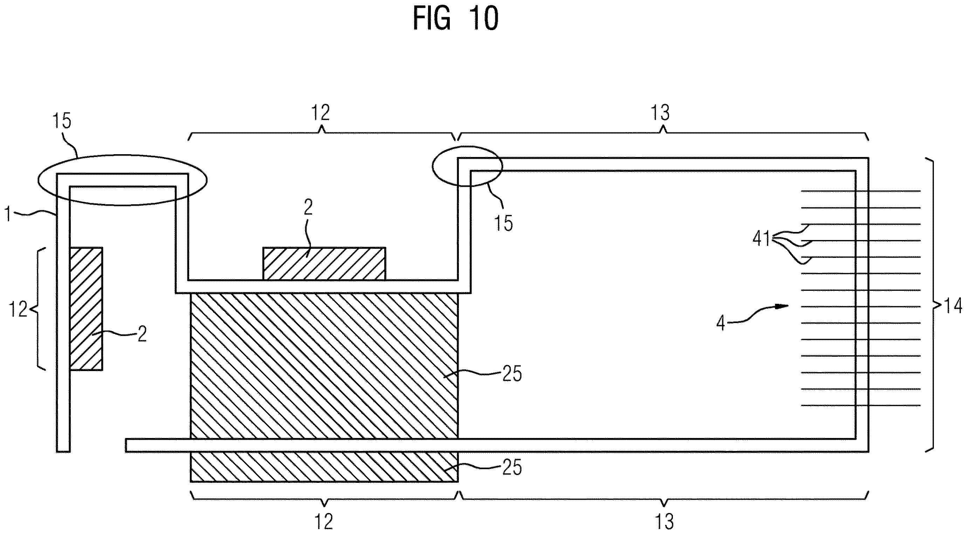

In der Figur 9 wird eine weitere alternative Ausgestaltung eines Kühlkörper 4 mittels Formung des Wärmeleitsystems 1, vergleichbar zur Figur 8 gezeigt, mit anderes orientierten Faltungen. In den Figuren 10 bis 12 sind noch weitere Ausführung des Wärmeleitsystems 1 gezeigt, insbesondere in Kombination mit alternativen elektrischen Bauteilen 2/25.

In der Figur 10 ist eine Ausführung des Wärmeleitsystems 1 in Kombination mit zwei elektrischen Bauteil 2 und Kondensatoren 25 gezeigt, welche sehr unterschiedliche Baugrößen aufweisen und verteilt angeordnet sind. Das dargestellt Wärmeleitsystem 1 erreicht über mehrere Stufen und Ecken 15 alle diese Bauteile 2/25 mit den sich beidseitig des Wärmeabgabeabschnitts 14 befindlichen Wärmeleitungen 13. Einer der Wärmeleitungsabschnitte 13 weist in Reihe zwei Wärmeaufnahmeabschnitte 12 auf.

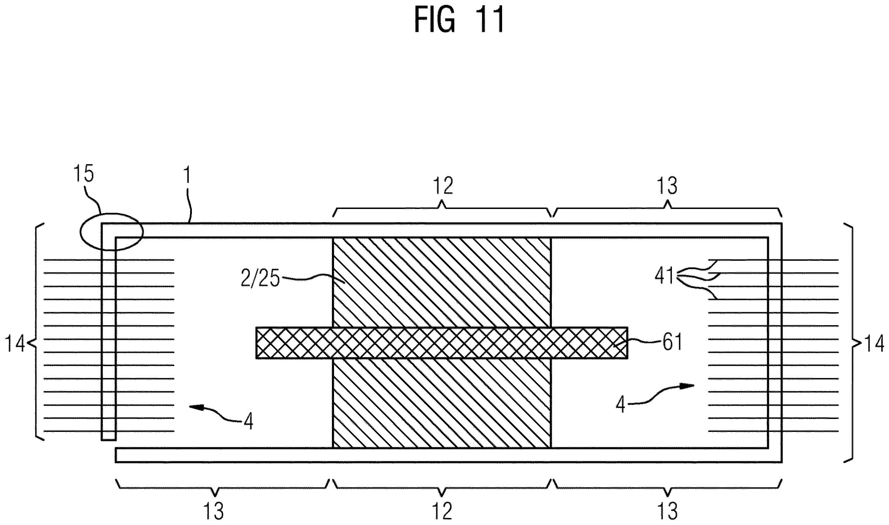

In der Figur 11 schließlich ist eine Ausführung des Wärmeleitsystems 1 mit zwei Wärmeabgabeabschnitten 14 gezeigt. Beginnend unten in der Darstellung mit einem ersten Wärmeaufnahmeabschnitt 12 entlang der Unterseite eines ersten Bauteils 2/25 führt ein erster Wärmetransportabschnitt 13 zu einem ersten Wärmeabgabeabschnitt 14 seitlich des Bauteils 2/25. Die Wärmeleitung weist beidseitig des Wärmeabgabeabschnitts 14 eine rechtwinklige Abbiegung auf. Oberhalb des zweiten Bauteils 2/25, welches sandwichartig oberhalb des ersten Bauteils 2/25 angeordnet ist, agiert die Wärmeleitung wieder als Wärmeaufnahmeabschnitt 12, wozu sie thermisch mit der Oberseite des zweiten Bauteils 2/25 verbunden ist. Das Wärmeleitsystem 1 weist dann zur anderen Seite der sandwichartigen Bauteilanordnung noch einen zweiten Wärmeabgabeabschnitt 14 auf. Mit dieser Variante können zweiseitige Lüfterkühlungen verbessert werden.

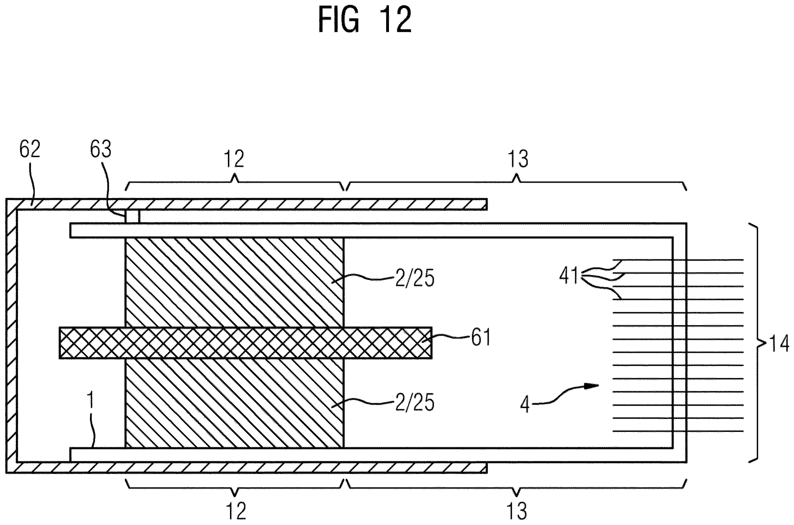

Die Figur 12 zeigt noch eine Ausführung des Wärmeleitsystems 1 in Kombination mit einem elektrischen Bauteil 2 in einem Gerätegehäuse 62. Dazu ist ein Verbinder 63, zum Beispiel eine Feder zum Andrücken, eine Schraube oder ein Lot vorgesehen, um das Wärmeleitsystem 1 mit dem Gehäuse 62 baulich zu verbinden.

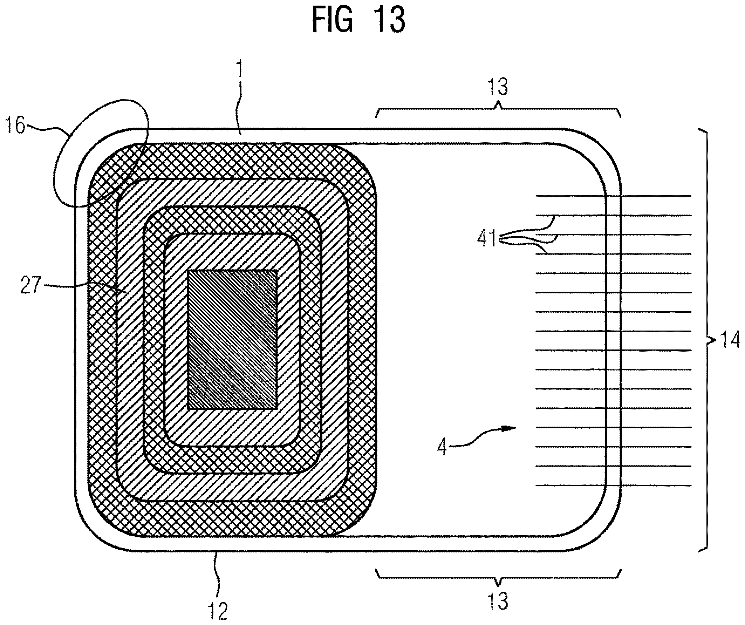

In der Figur 13 schließlich ist eine thermische Anbindung einer nicht-ebenen Außenflächen eines elektrischen Bauteils 2 gezeigt. Die kann beispielsweise eine Drosselwicklung sein. Das Wärmeleitsystem 1 wird bevorzugt mittels einer an eine formangepasste PHP realisiert, welche sich gebogen 16 um die Drosselwicklung schmiegen kann.

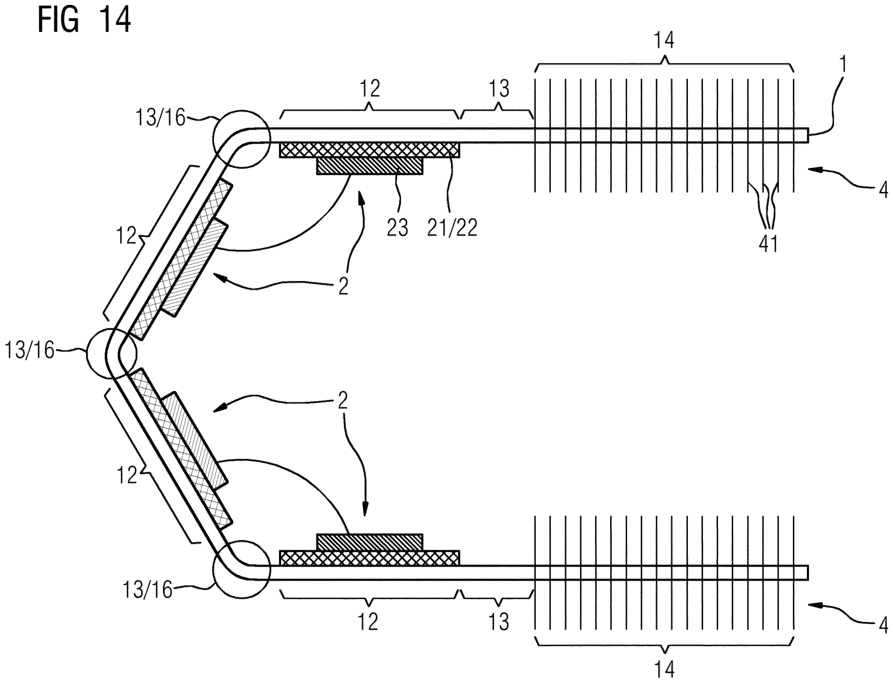

In der Figur 14 ist eine thermische Anbindung nicht planar oder parallel angeordneter Verlustleistungskomponenten 2 gezeigt. Die Wärmetransportabschnitte 13 zwischen vier thermisch angebundener Komponenten 2 weisen jeweils eine 120° Biegung 16 auf. Somit können alle Komponenten 2 in Reihe an das Wärmeleitsystem 1 angeschlossen werden. In der Figur 14 ist wieder eine Variante gezeigt, in der das Wärmeleitsystem beidendig einen Wärmeabgabeabschnitt 14 aufweist.

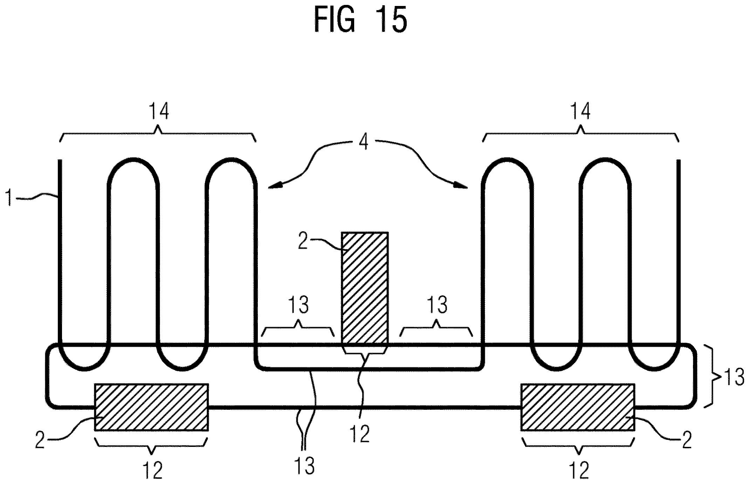

In den Figuren 15 bis 18 schließlich sind noch verschiedene Ausformungsbeispiele 15/16 für Wärmeleit- und Wärmeabgabebereiche 13/14 gezeigt. Eine derartige Formbarkeit ist vorteilhaft mittels pulsierender Heatpipes realisierbar. Geeignet dafür sind PHPs mit einer minimale Kanalausdehnung im Bereich von 0,5 mm bis 5 mm. Ein weiterer Vorteil der PHP ist, dass bei entsprechender Auslegung zusätzlich zum Wärmeabtransport 14 eine Homogenisierung der Temperatur zwischen verschiedenen Modulen 2 erwirkt werden kann. Hierdurch können bestimmte Arten von Halbleiterbauteilen 2 leichter parallelgeschaltet werden.

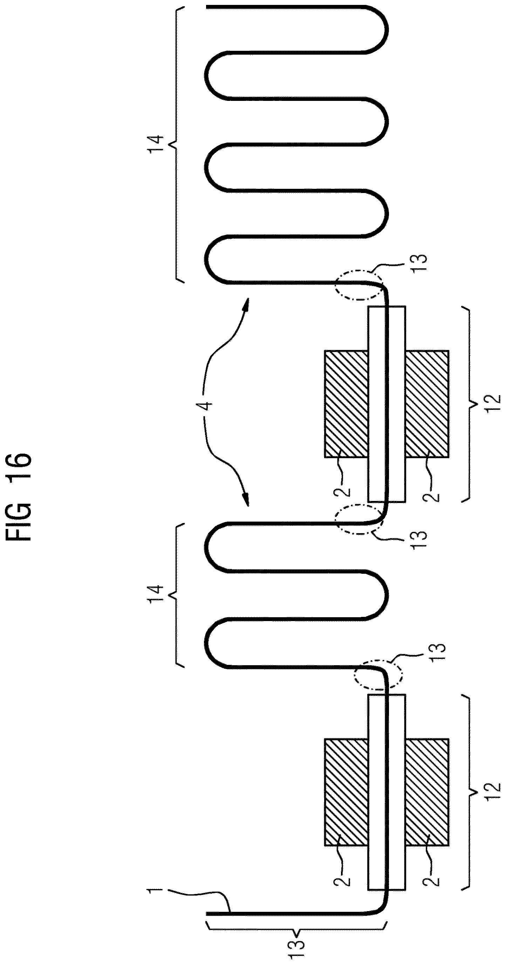

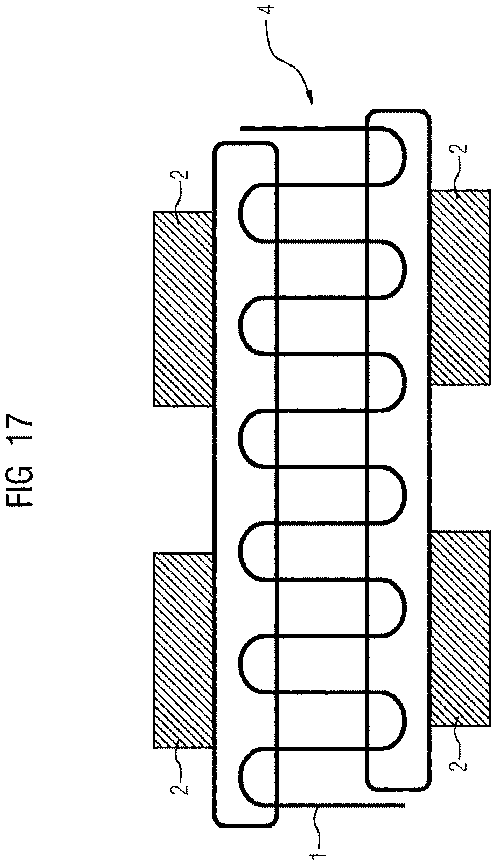

Die Figur 15 zeigt eine thermische Anbindung nicht planar angeordneter Elektronikmodule 2 an eine frei designte PHP als Wärmeleitsystem 1 und Kühlkörper 4, die Figuren 16 und 17 zeigen weitere Varianten einer beidseitigen Anbindung von Elektronikmodulen 2 an eine frei designte PHP als Wärmeleitsystem 1 und Kühlkörper 4. Dabei können die Elektronikmodule (2) Leistungshalbleiterbaugruppen darstellen, beziehungsweise Leiterplatten mit Leistungshalbleitern.

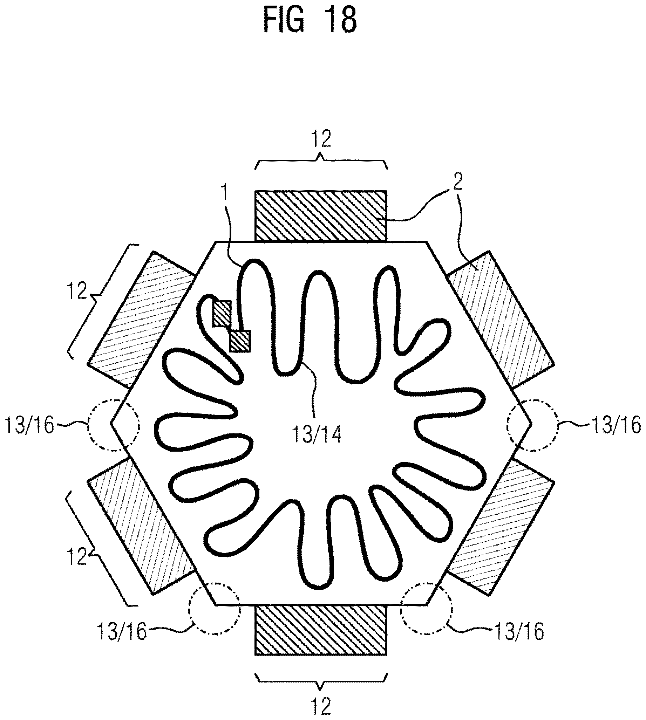

Die Figur 18 schließlich zeigt noch eine thermische Anbindung konzentrisch angeordneter Elektronikmodule 2 an einer frei designte PHP als Wärmeleitsystem 1 und Kühlkörper 4. Derartige Ausgestaltungen sind bevorzugt mittels Wärmeleitsystemen 1 in Röhren-, Strang- oder Kanalform realisiert. Besonders bevorzugt werden die in den Figuren 15 bis 18 gezeigten Ausgestaltungen mittels Strangpress-PHPs, insbesondere aus Aluminium realisiert. Diese weisen eine fünfmal höhere Wärmeleitung als beispielsweise Vollkupferwärmeleitungen auf. Zudem sind Strangpressprofile von Lieferanten zukaufbar und vollautomatisiert faltbar und lötbar.

Zudem verdeutlichen die gezeigten Beispiele wie die großen Wärmeleitstrecken zwischen Wärmequelle und Senke zu neuen Designfreiheiten beitragen.

### Bezugszeichen:

- 1: Wärmeleitsystem, z.B. Heatpipe
- 12: Wärmeaufnahmeabschnitt
- 13: Wärmetransportabschnitt
- 14: Wärmeabgabeabschnitt
- 15: Stufe im Wärmeleitsystem, z.B. zur Anpassung an Bauteilhöhen
- 16: Gekrümmter Abschnitt im Wärmeleitsystem, z.B. zur Anpassung an Bauteilform
- 2: zu entwärmende elektrische Komponente, Elektronikmodul, insbesondere Leistungsmodul
- 21: Substrat, z.B. Bodenplatte eines Leistungsmoduls
- 22: elektrisch leitende Schicht, z.B. Kupferschicht
- 23: elektrisches Bauteil, z.B. Chip
- 24: Gehäuse, z.B. Chipverpackung oder Modulgehäuse,
- 25: elektrische Bauteile, z.B. Kondensatoren
- 26: Halterung, insbesondere Schraube
- 27: zu entwärmende elektrische Komponente, z.B. Drosselwicklung
- 4: Kühlkörper
- 41: Kühlrippen
- 6: Halterung
- 61: Substrat, z.B. Leiterplatte
- 62: Gehäuse, z. B. Gerätegehäuse
- 63: Verbinder, z.B. Feder zum Andrücken, Schraube, Lot, etc.

## Patentansprüche

1. Wärmeleitsystem (1), mit wenigstens einem Wärmeaufnahmeabschnitt (12), welcher für eine thermisch leitende Anbindung an eine zu entwärmende elektrische Komponente (2) vorgesehen ist, mit wenigstens einem Wärmeabgabeabschnitt (14), welcher wenigstens ein oberflächenvergrößerndes Mittel aufweist, und mit wenigstens einem Wärmetransportabschnitt (13) zwischen Wärmeaufnahmeabschnitt (12) und Wärmeabgabeabschnitt (14), wobei das Wärmeleitsystem (1) derart für einen Betrieb einer Zwei-Phasen-Kühlung eingerichtet ist, indem eine durchgängige hydraulische Verbindung zwischen dem wenigstens einen Wärmeabgabeabschnitt (14), dem wenigstens einen Wärmetransportabschnitt (13) und dem wenigstens einen Wärmeaufnahmeabschnitt (12) vorgesehen ist.

2. Wärmeleitsystem (1) nach Anspruch 1, mit wenigstens einem weiteren Wärmeaufnahmeabschnitt (12), welcher für eine thermisch leitende Anbindung an eine weitere zu entwärmende elektrische Komponente (2) vorgesehen ist, mit wenigstens einem weiteren Wärmetransportabschnitt (13) zwischen dem weiteren Wärmeaufnahmeabschnitt (12) und dem Wärmeabgabeabschnitt (14).

3. Wärmeleitsystem (1) nach Anspruch 1 oder 2, welches als Vapor Chamber ausgestaltet ist.

4. Wärmeleitsystem (1) nach Anspruch 1 oder 2, welches einen Zwei-Phasen-Thermosiphon umfasst.

5. Wärmeleitsystem (1) nach Anspruch 1 oder 2, welches eine Heatpipe, insbesondere eine pulsierende Heatpipe umfasst.

6. Wärmeleitsystem (1) nach einem der vorstehenden Ansprüche, wobei der Wärmetransportabschnitt (13) eine Mindestlänge von 0,1 m, 0,5 m oder 1 m aufweist.

7. Wärmeleitsystem (1) nach einem der vorstehenden Ansprüche, wobei der wenigstens eine Wärmeaufnahmeabschnitt (12), Wärmetransportabschnitt (13) und Wärmeabgabeabschnitt (14) fügestellenfrei ausgebildet sind.

8. Wärmeleitsystem (1) nach einem der vorstehenden Ansprüche, welches in länglicher Form ausgebildet ist, wobei sich Wärmeaufnahmeabschnitt (12), Wärmetransportabschnitt (13) und Wärmeabgabeabschnitt (14) entlang dieser länglichen Form aneinanderreihen und ineinander übergehen, insbesondere fügestellenfrei ineinander übergehen.

9. Wärmeleitsystem (1) nach einem der vorstehenden Ansprüche 5 bis 8, wobei der Wärmetransportabschnitt (13) wenigstens eine Formadaption an das zu entwärmende elektrische System (15/16) aufweist.

10. Wärmeleitsystem (1) nach einem der vorstehenden Ansprüche, wobei der Wärmeabgabeabschnitt (14) mittels des wenigstens einen oberflächenvergrößernden Mittels einen Kühlkörper (4) ausbildet.

11. Wärmeleitsystem (1) nach Anspruch 10, wobei der Kühlkörper (4) Kühlrippen (41) aufweist.

12. Wärmeleitsystem (1) nach Anspruch 10 oder 11, wobei der Wärmeabgabeabschnitt (14) gekrümmte, wechselseitig gekrümmte, mäanderförmige oder U-förmig ausgebildete Abschnitte aufweist.

13. Elektrische Komponente (2), insbesondere Leistungshalbleitermodul, angeordnet mit einem Wärmeleitsystem (1) nach einem der Ansprüche 1 bis 12, wobei die elektrische Komponente (2) thermisch leitend mit dem Wärmeleitsystem (1) verbunden ist.

14. Elektrisches Gerät, insbesondere Stromrichter, mit einem Wärmeleitsystem (1) nach einem der Ansprüche 1 bis 12 oder mit einer elektrischen Komponente (2), insbesondere einem Leistunghalbleitermodul, nach Anspruch 13.

15. Herstellungsverfahren für ein Wärmeleitsystem (1) nach einem der Ansprüche 1 bis 12, bei dem eine Wärmeleitung, insbesondere ein Strangpressprofil, in eine Form entsprechend einer Außengestalt einer zu entwärmende elektrischen Komponente (2) und/oder einer Anordnung wenigstens einer zu entwärmenden elektrischen Komponente (2) gefaltet wird.
